Europäisches Patentamt

European Patent Office

Office européen des brevets

(19)

(11) **EP 0 453 376 B1**

(12) **FASCICULE DE BREVET EUROPEEN**

(45) Date de publication et mention
de la délivrance du brevet:
**09.10.1996 Bulletin 1996/41**

(51) Int Cl.[6]: **H03K 17/10**

(21) Numéro de dépôt: **91420073.8**

(22) Date de dépôt: **05.03.1991**

(54) **Interrupteur statique moyenne tension**

Statischer Schalter für mittlere Spannung

Static switch for medium voltage

(84) Etats contractants désignés:
**BE CH DE ES GB IT LI SE**

(30) Priorité: **16.03.1990 FR 9003508**

(43) Date de publication de la demande:
**23.10.1991 Bulletin 1991/43**

(73) Titulaire: **SCHNEIDER ELECTRIC SA**
**F-92100 Boulogne-Billancourt (FR)**

(72) Inventeurs:
• **Kevorkian, Antoine**
**F-38050 Grenoble Cédex (FR)**
• **Raulet, Claude**
**F-38050 Grenoble Cédex (FR)**
• **Rojat, Gérard**
**F-38050 Grenoble Cédex (FR)**

(74) Mandataire: **Jouvray, Marie-Andrée et al**
**Schneider Electric SA,**
**Sce. Propriété Industrielle**
**38050 Grenoble Cédex 09 (FR)**

(56) Documents cités:
**EP-A- 0 215 707** **DE-A- 3 100 795**
**DE-A- 3 335 475**

• **REVIEW OF SCIENTIFIC INSTRUMENTS, vol. 60,
no. 8, août 1989, pages 2614-2627, New York, US;
X. XIE et al.: "Picosecond time-resolved circular
dichroism spectroscopy: experimental details
and applications"**

EP 0 453 376 B1

## Description

L'invention concerne un interrupteur statique moyenne tension comportant une pluralité de semi-conducteurs de puissance commandables en tension, comportant chacun une grille, une source et un drain, connectés en série avec une impédance de charge aux bornes d'une tension d'alimentation, et un dispositif de commande constituant avec lesdits semi-conducteurs une pluralité d'étages comportant chacun un des semi-conducteurs.

Les dispositifs connus constitués par la mise en série de transistors MOS de puissance sont commandés par l'intermédiaire de transformateurs d'impulsions. Ce type de commande n'est pas adapté à la commande en statique, c'est à dire à très faible fréquence.

Le document EP-A-215 707 décrit un interrupteur statique dont le dispositif de commande comporte une entrée de commande unique constituée par des première et seconde bornes de commande respectivement connectées à la source et à la grille du semi-conducteur d'un premier étage, de rang un, un condensateur, une résistance et une diode étant connectés en parallèle entre les grilles de deux semi-conducteurs de puissance adjacents, lesdites diodes étant polarisées en inverse lorsque l'interrupteur est ouvert.

Le document DE-A-3100795 décrit un commutateur comportant une série de transistors à effet de champ connectés en série et dont les grilles sont connectées par des diodes. Pour accélérer le blocage des transistors, un semi-conducteur, connecté entre la grille et la source de chaque transistor à effet de champ de rang supérieur à 1, est rendu conducteur lorsque la tension de commande du commutateur passe à zéro.

L'invention a pour but un interrupteur statique moyenne tension pouvant fonctionner aussi bien en statique qu'à moyenne fréquence (jusqu'à 1MHz environ) et possédant une bonne immunité aux fortes variations de la tension d'alimentation.

Ce but est atteint par un interrupteur selon la revendication 1.

Un tel interrupteur, à ligne de commande capacitive constituée par lesdits condensateurs et la capacité interne grille-drain du semi-conducteur du dernier étage, permet de commuter très rapidement des tensions relativement élevées, la vitesse de commutation étant très proche de celle d'un transistor individuel. Le nombre de semi-conducteurs, de préférence de type MOS, connectés en série est fonction de la tension d'alimentation et de la tension drain-source Vds maximale admissible. A titre d'exemple deux semi-conducteurs seront utilisés pour une tension d'alimentation de 380V, trois pour une tension de 1500V, cinq pour une tension de 2000 à 2500V si la tension Vds maximale est de 500V.

Lorsque le nombre d'étages augmente, le courant dans la charge est limité par la tension de commande. Selon un perfectionnement de l'invention, pour permettre la commutation d'un courant du même ordre de grandeur que le courant nominal acceptable par les semi-conducteurs de puissance, chaque étage comporte un régulateur de tension destiné à limiter la tension grille-source appliquée au semi-conducteur de puissance dudit étage.

Un tel régulateur de tension comporte de préférence une première borne d'entrée, connectée à la cathode de la diode associée à l'étage pour les étages de rang supérieur à un, et à la seconde borne de commande pour l'étage de rang un, une seconde borne, d'entrée-sortie, connectée au drain du semi-conducteur de puissance de l'étage considéré, et une troisième borne, de sortie, connectée à la grille du semi-conducteur de puissance de l'étage considéré.

Afin d'égaliser les tensions drain-source des semi-conducteurs de puissance des différents étages une résistance est de préférence connectée en parallèle sur le condensateur et la diode connectant les grilles de deux semi-conducteurs de puissance adjacents, et une résistance additionnelle est connectée entre la grille et le drain du semi-conducteur de puissance de l'étage de rang le plus élevé.

D'autres avantages et caractéristiques ressortiront plus clairement de la description qui va suivre de mode particuliers de réalisation de l'invention, donnés à titre d'exemples non limitatifs et représentés aux dessins annexés sur lesquels:

La figure 1 illustre un interrupteur à ligne de commande capacitive.

La figure 2 représente un perfectionnement de l'interrupteur selon la figure 1.

La figure 3 représente un mode particulier de réalisation d'un détecteur de tension d'un interrupteur selon la figure 2.

La figure 4 représente un perfectionnement à l'interrupteur selon la figure 3.

La figure 5, illustre un mode particulier de réalisation d'un régulateur de tension d'un interrupteur selon la figure 4.

La figure 6 représente un module standard de commande d'un étage d'un interrupteur.

Les figures 7 et 8 illustrent un mode particulier de réalisation des condensateurs Ci et des résistances ri de chaque étage.

La figure 9 représente un mode particulier de réalisation d'un interrupteur à cinq étages utilisant des modules standards selon la figure 6.

Sur les figures 10A à 10L sont représentées les formes d'onde de divers signaux d'un interrupteur selon la figure 9 lors de sa fermeture, les figures 11A à 11L illustrent les formes d'onde des mêmes signaux lors de l'ouverture de l'interrupteur.

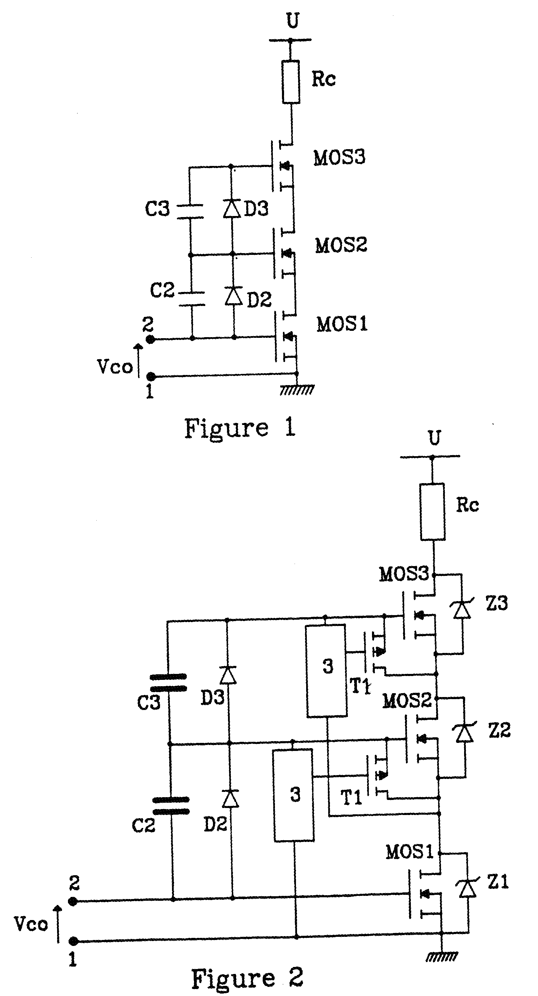

Sur la figure 1, l'interrupteur comporte trois transistors de puissance MOS1, MOS2 et MOS3, de type MOSFET, connectés en série avec une résistance de charge Rc entre la masse et une tension d'alimentation U. Un condensateur C2 est connecté entre les grilles des transistors MOS1 et MOS2 des premier et second étages, et un condensateur C3 entre les grilles des transistors MOS2 et MOS3 des second et troisième étages. Une diode D2 est connectée en parallèle sur le condensateur C2 et une diode D3 en parallèle sur le condensateur C3. Sur la figure, les transistors sont des MOS de type N, la tension d'alimentation U est positive par rapport à la masse et l'anode de la diode D2 est connectée à la grille du transistor MOS1, l'anode de la diode D3 étant connectée à la grille du transistor MOS2. Des bornes 1 et 2 de commande de l'interrupteur sont respectivement connectées à la source et à la grille du transistor MOS1.

L'interrupteur étant ouvert, les transistors MOS1, MOS2 et MOS3 bloqués, l'application d'une tension de commande Vco positive entre les bornes de commande provoque la conduction des transistors et, en conséquence, la fermeture de l'interrupteur. En effet, l'impulsion de commande est transmise aux grilles des transistors par la ligne de commande capacitive, constituée par les condensateurs C2 et C3 et par la capacité interne grille-drain du transistor MOS3, et l'application d'une tension grille-source Vgs supérieure à sa tension de seuil S rend conducteur le transistor concerné. Le transistor MOS1 conduisant, le condensateur C2 se décharge à travers la capacité interne grille-source du transistor MOS2 et la jonction drain-source du transistor MOS1. Il en va de même pour les étages supérieurs, le condensateur C3 se déchargeant à travers la capacité interne grille-source du MOS3 et les jonctions drain-source des MOS2 et MOS1. Le potentiel de la source de chacun des transistors est ramené sensiblement à la masse du fait de la conduction des étages inférieurs.

Les capacités grille-source des transistors des étages supérieurs sont ensuite maintenus chargées, à une tension grille-source Vgs suffisante pour garantir la conduction des transistors, par un courant traversant la diode D2 pour le MOS2, et les diodes D2 et D3 pour le MOS3. En effet, après la période transitoire de fermeture de l'interrupteur, les tensions grille-source des transistors MOS2 et MOS3 sont respectivement fixées par:

$$Vgs2 = Vco - Vd2 - Vds1 \qquad (1)$$

$$Vgs3 = Vco - Vd2 - Vd3 - Vds1 - Vds2 \qquad (2)$$

Vds1 et Vds2 étant respectivement les tensions drain-source des transistors MOS1 et MOS2, Vd2 et Vd3 les tensions aux bornes des diodes D2 et D3.

Pour bloquer les transistors et ouvrir l'interrupteur, la tension Vco de commande est ramenée à zéro. le transistor MOS1, dont la tension grille-source est ramenée à zéro, se bloque. Les tensions grille-source des transistors MOS2, et MOS3 sont alors données par:

$$Vgs2 = Vc2 - Vds1 \qquad (3)$$

$$Vgs3 = Vc2 + Vc3 - Vds1 - Vds2 \qquad (4)$$

Vc2 et Vc3 étant respectivement les tensions aux bornes des condensateurs C2 et C3.

Or, à l'instant du blocage les condensateurs C2 et C3, qui étaient court-circuités respectivement par les diodes D2 et D3, sont chargés à des tensions Vc2 et Vc3 voisines de -0,7V, tandis que les capacités internes drain-source des transistors MOS1 et MOS2 sont chargées à des tensions Vds1 et Vds2 qui sont typiquement voisines de 5V. Une tension grille-source négative (-5,7V) est donc appliquée aux transistors MOS des étages supérieurs qui se bloquent.

En raison des tolérances des différents composants, tous les transistors ne se bloquent pas vraiment simultanément. Si l'un des transistors se bloque plus rapidement que les autres, il voit la totalité de la tension d'alimentation entre ses électrodes drain et source. Si la tension d'alimentation est supérieure à sa tension de claquage, une diode Zener de puissance (Z1,Z2,Z3, figure 2), de type transil, est disposée en parallèle entre le drain et la source du transistor de puissance associé de manière à le protéger. Ces diodes servent également à écrêter les surtensions produites par l'ouverture de l'interrupteur dans le cas d'une charge inductive. La diode Zener peut être remplacée par un circuit d'aide à la commutation constitué par un réseau RCD.

Le circuit de commande à ligne de commande capacitive selon la figure 1, permet d'ouvrir et de fermer très rapidement l'interrupteur. Cependant son immunité aux fortes variations de la tension d'alimentation n'est pas parfaite et cette immunité peut être améliorée de la manière décrite en référence aux figures suivantes.

Selon un premier perfectionnement du circuit selon la figure 1, représenté à la figure 2, le blocage du transistor de puissance de chaque étage supérieur (i≠1) est assuré par un transistor MOS, T1, connecté en parallèle sur la jonction grille-source du transistor de puissance associé. Lorsque le transistor T1 conduit, il court-circuite la grille et la source du transistor de puissance associé qui se bloque. La grille du transistor T1 est connectée à la sortie d'un détecteur de tension 3. Ce dernier reçoit en entrée une tension représentative de la tension drain-source Vds de l'étage inférieur (i-1).

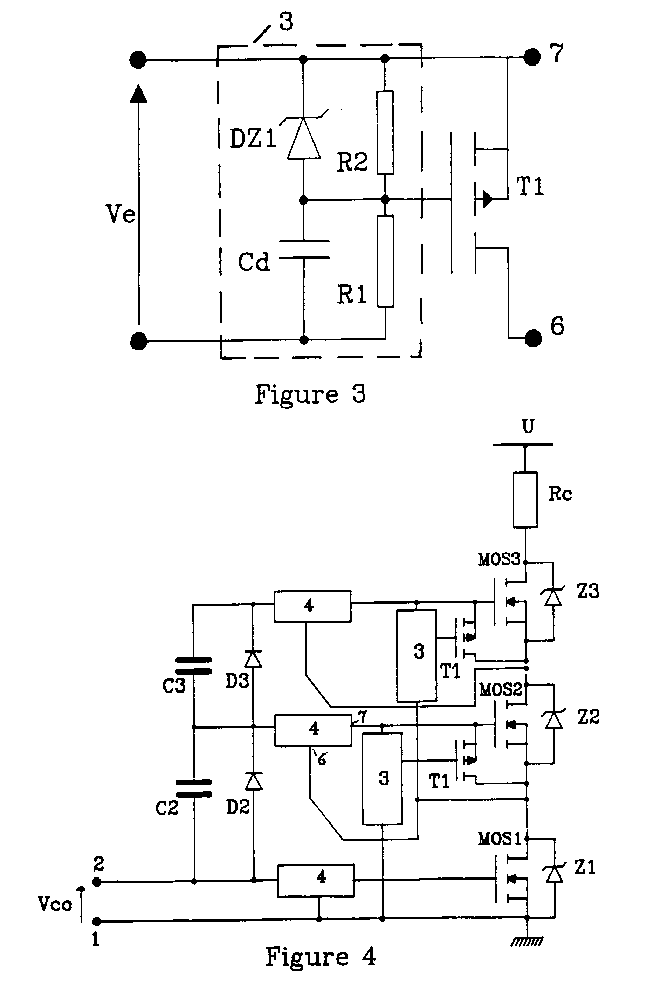

Dans le mode particulier de réalisation du détecteur 3 représenté à la figure 3, une tension d'entrée Ve, représentative de la tension Vds de l'étage inférieur, est appliquée aux bornes d'entrée du détecteur. Un diviseur de tension, comportant deux résistances R1 et R2 en série, est connecté entre ces bornes d'entrée. La tension aux bornes de l'une des résistances, R2 sur la figure, forme la tension de sortie du détecteur appliquée entre la grille et la source du transistor T1. Le transistor T1 devient conducteur dès que sa tension grille-source dépasse sa tension seuil, c'est à dire dès que la tension Ve appliquée à l'entrée du détecteur dépasse un seuil prédéterminé. Une diode Zener DZ1, disposée en parallèle sur la résistance R2, protège la jonction grille-source du transistor T1. Un condensateur Cd, en parallèle sur la résistance R1, améliore la réponse dynamique du détecteur.

Dans le mode de réalisation selon la figure 2, le transistor T1 est un transistor MOS de type P dont la source et le drain sont respectivement connectés à la grille et à la source du transistor de puissance, MOS2 ou MOS3, associé. Les bornes d'entrée du détecteur 3 du second étage, associé au transistor de puissance MOS2, sont connectées respectivement à la grille du transistor MOS2 et à la source du transistor MOS1 de l'étage inférieur. La tension Ve d'entrée du détecteur est donnée par:

$$Ve = Vds1 + Vgs2 \qquad (5)$$

Lorsque l'interrupteur est fermé, les transistors MOS1 et MOS2 conduisent. La tension Vds1 est de l'ordre du volt, la tension Vgs2 voisine de 15V. Le diviseur de tension du détecteur est tel que la tension aux bornes de la résistance R2 est alors inférieure au seuil de déclenchement du transistor T1 qui est donc bloqué. Lorsque la tension de commande Vco est ramenée à zéro, le transistor de puissance MOS1 du premier étage se bloque et sa tension Vds1 augmente très rapidement. Il en va de même de la tension Ve et dès que celle-ci dépasse un seuil prédéterminé correspondant au dépassement de la tension de déclenchement du transistor T1 par la tension de sortie du détecteur 3, le transistor T1 devient conducteur et court-circuite le transistor de puissance MOS2 qui se bloque. La tension Vds2 augmente alors très rapidement et cette augmentation est détectée par le détecteur 3 du troisième étage, associé au transistor de puissance MOS3. le détecteur du troisième étage rend conducteur le transistor T1 associé, qui court-circuite la grille et la source du transistor MOS3, le bloquant à son tour. En position d'ouverture de l'interrupteur, les transistors T1 restent conducteurs et bloquent en permanence les transistors de puissance des étages supérieurs.

Le nombre d'étages de l'interrupteur est fonction de la tension d'alimentation U. A titre d'exemple, pour une tension U de 1200V, un interrupteur à trois étages peut être réalisé avec des transistors MOS de puissance dont la tension Vds maximum est de l'ordre de 500V. Pour une tension d'alimentation de 2000V à 2500V on utilisera cinq étages en série.

Lorsqu'un échelon de tension est appliquée à l'entrée de commande Vco, il est transmis par la ligne capacitive aux étages supérieurs avec une atténuation d'amplitude. Si les capacités des condensateurs de la ligne capacitive sont égales, pour un interrupteur à trois étages, l'atténuation est telle que la tension Vgs1 appliquée au 1er étage est égale à Vco, la tension Vgs2 est 2 Vco/3 et la tension Vgs3 de Vco/3. A titre d'exemple, si Vco=15V, lors de l'application de la tension de commande on obtient Vgs1=15V, Vgs2=10V et Vgs3=5V. En pratique, l'atténuation est légèrement supérieure à sa valeur théorique et la tension Vgs3 peut être encore plus faible, de l'ordre de 3V. Pour propager par la ligne capacitive une tension non négligeable non seulement sur le 2ème étage, mais également sur les étages supérieurs, il faut donc une tension de commande Vco élevée.

Par ailleurs, après la période transitoire de fermeture, lorsque tous les transistors de puissance sont conducteurs, la tension Vgsi du transistor de puissance du ième étage est donné par:

$$Vgsi = Vco - (Vd + Rdson . Ich) (i-1) \qquad (6)$$

où Rdson est la résistance drain-source d'un transistor de puissance à l'état passant, Ich le courant de charge traversant l'interrupteur et Vd=0,7V la tension aux bornes de la diode Di (D2,D3...) associée à l'étage.

Pour maintenir conducteurs les transistors de puissance de tous les étages, il est indispensable que la tension Vgsi du dernier étage soit supérieure à la tension grille-source minimum de déclenchement du transistor de puissance considéré. Pour un transistor de puissance de type donné, le courant de charge et la tension d'alimentation U, fixant le nombre minimum d'étages, étant prédéterminés, ceci implique l'utilisation d'une tension de commande Vco minimum, conformément à l'équation (6).

A titre d'exemple, si Rdson=0,4 Ohms, Vgs=8V pour Ich=13A, la tension de commande Vco minimum à appliquer à un interrupteur à cinq étages est de 32V. Or, cette tension qui est appliquée à la grille du premier étage est supérieure à la tension Vgs1 admissible par le transistor MOS1.

Si la tension Vco de commande est limitée à une tension admissible par le transistor de puissance MOS1 du premier étage, par exemple 15V, le courant de charge maximal pouvant être obtenu tout en maintenant la tension Vgs5 du cinquième étage à une valeur suffisante, par exemple 6V, est, selon l'équation (6), de 3,8A.

La tension de commande Vco doit donc être suffisamment élevée pour permettre l'obtention d'un courant de charge prédéterminé avec un nombre minimum d'étages fixé par la tension d'alimentation.

Lorsque la tension de commande Vco nécessaire est supérieure à la tension Vgs1 admissible par le premier étage, il est nécessaire de protéger la jonction grille-source du transistor de puissance du premier étage. Cette protection pourrait être réalisée au moyen d'une diode Zener appropriée interposée entre la grille du transistor MOS1 et la borne de commande 2 de l'interrupteur, une résistance étant connectée entre la grille et la source du transistor MOS1.

Cependant, dans les étages supérieurs la tension Vgs est fonction du courant de charge, conformément à l'équation (6). Si l'on reprend l'exemple d'un interrupteur à cinq étages pour lequel la tension de commande Vco est de 32V, on a, pour un courant de charge de 13A, Vgs5=8,4V. Par contre, à vide (Ich=o), Vgs5=29,2V, Vgs4=29,9V, Vgs3=31,4V et Vgs2=31,3V. Dans ce cas, il est nécessaire de protéger également les jonctions grille-source des transistors de puissance de tous les étages supérieurs pour des courants de drain faibles, sans limiter la tension Vgs pour des courants de drain forts. On ne peut alors utiliser une diode Zener seule.

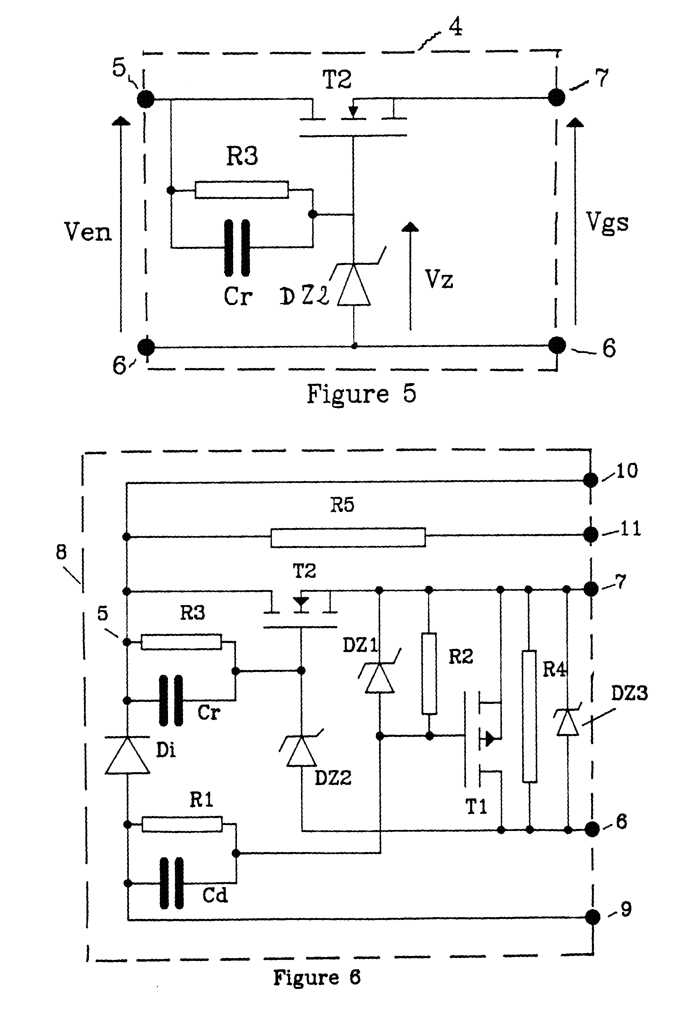

Selon un perfectionnement de l'invention chaque étage, y compris le premier, comporte un régulateur de tension 4 destiné à réguler la tension grille-source de commande appliquée au transistor de puissance de l'étage (figure 4).

Un mode de réalisation particulier du régulateur 4 est illustré à la figure 5. La tension d'entrée Ven du régulateur est appliquée entre une première borne 5 d'entrée et une seconde borne 6, d'entrée-sortie, au montage en série d'une résistance R3 et d'une diode Zener DZ2. La première borne 5 est connectée à une troisième borne 7, de sortie, par l'intermédiaire d'un transistor T2, dont l'électrode de commande est reliée au point commun à la résistance R3 et à la diode Zener DZ2. Le transistor T2 est de préférence un transistor de type MOSFET. Tant que la tension d'entrée Ven est inférieure à la tension Vz de la diode Zener DZ2, la tension Vgs de sortie suit sensiblement linéairement la tension d'entrée, la différence entre les deux tensions correspondant sensiblement à la tension grille-source, par exemple 5V, du transistor T2. Lorsque la tension d'entrée atteint ou dépasse la tension Vz, la tension de sortie reste constante et égale à la différence entre la tension Vz et la tension grille-source du transistor T2. Pour améliorer le dynamique du régulateur, un condensateur Cr peut être disposé en parallèle sur la résistance R3.

Comme représenté sur la figure 4, la borne d'entrée 5 du régulateur 4 du premier étage est connectée à la borne de commande 2 et pour les étages de rang supérieur à un, à la cathode de la diode associée à cet étage: cathode de D2 pour le second étage comportant le transistor MOS2, cathode de D3 pour le troisième étage comportant le transistor MOS3. Les bornes 6 d'entrée-sortie et 7 de sortie du régulateur sont respectivement connectées à la source et à la grille du transistor de puissance de l'étage.

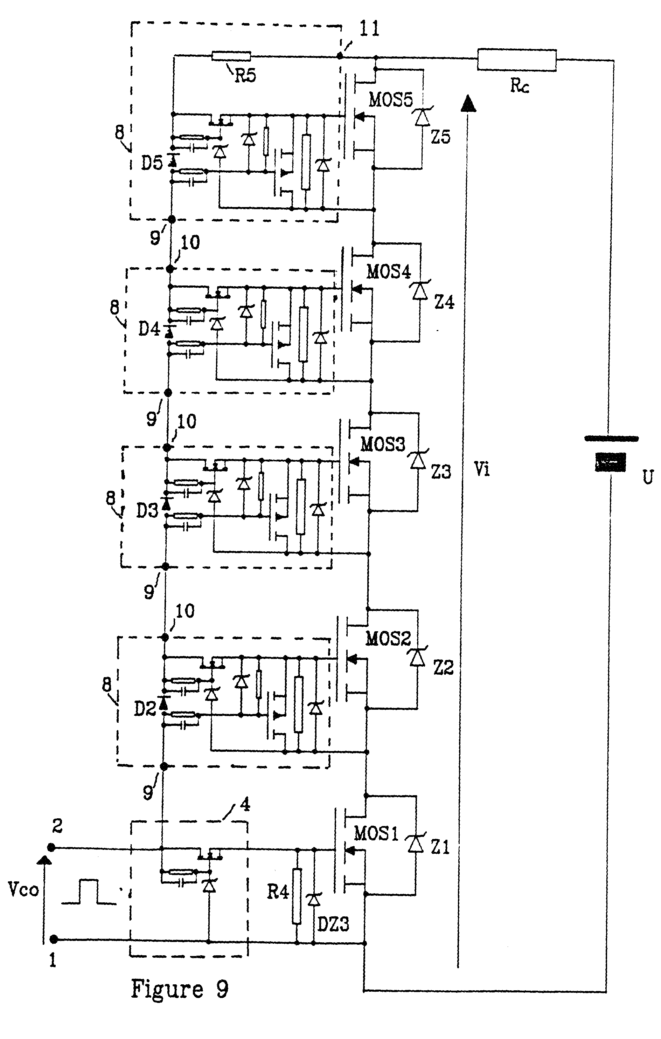

La figure 6 illustre un module 8 standard de commande d'un étage supérieur d'un interrupteur, combinant un détecteur de tension selon la figure 3 et un régulateur selon la figure 5, et la figure 9 représente un interrupteur à cinq étages comportant un tel module standard pour la commande de ses second, troisième, quatrième et cinquième étages, le premier étage ne comportant pas de détecteur mais uniquement un régulateur 4.

Le module standard 8 comporte deux bornes de contrôle destinées à être connectées respectivement à la source et à la grille du transistor de puissance MOSi de l'étage correspondant, d'ordre i, i étant supérieur à 1. Ces bornes de contrôle sont respectivement connectées aux bornes de sortie 6 et 7 du régulateur 4 ainsi qu'au drain et à la source du transistor T1. Une résistance R4 et une diode Zener DZ3 sont, de manière classique, disposées en parallèle entre ces bornes de contrôle pour protéger le transistor de puissance associé contre les surtensions et contre les perturbations extérieures. Chaque module comporte une borne d'entrée 9 connectée à une borne de sortie 10 par la diode Di de l'étage correspondant. La borne d'entrée 9 du module 8 d'un étage est connectée à la borne de sortie 10 du module 8 de l'étage inférieur, la borne d'entrée du module du second étage étant connectée à l'entrée de commande 2. Un module standard comporte une seconde borne de sortie 11, connectée à la première borne de sortie 10 par l'intermédiaire d'une résistance R5. Cette borne de sortie 11 est utilisée, en remplacement de la borne de sortie 10, pour le module de l'étage le plus élevé. Ainsi sur la figure 9, la sortie 11 du module 8 du cinquième étage est connectée au drain du transistor de puissance MOS5. On pourrait bien entendu concevoir des modules différents pour les étages intermédiaires (deuxième, troisième et quatrième étages sur la figure 9) et pour l'étage supérieur (cinquième étage sur la figure 9), mais la prévision des deux bornes de sortie 10 et 11 permet de n'avoir qu'un seul module, standard, pour tous les étages, sauf le premier.

Dans le module 8, la tension d'entrée Ve du détecteur de tension 3 n'est pas, comme dans les figures 2 et 4, mesurée directement entre la grille du transistor de puissance de l'étage et la source du transistor de puissance de l'étage inférieur adjacent.

En effet, le détecteur 3 de l'étage i intervenant pour détecter une augmentation de la tension Vds (i-1) du transistor de puissance de l'étage inférieur adjacent lorsque celui-ci se bloque, c'est à dire lorsque la tension Vgs (i-1) s'annule, la tension entre grilles des transistors de puissance de deux étages adjacents est également représentative de la tension Vds (i-1) et peut être utilisée comme tension d'entrée Ve du détecteur. Dans le mode de réalisation particulier des figures 6 et 9, comportant de plus un régulateur 4 par étage, on utilise comme tension d'entrée du détecteur 3 d'un étage i (i≠1), la tension entre les grilles des transistors de puissance des étages i et i-1 diminuée de la tension drain-source, sensiblement constante, du transistor T2 du régulateur 4 de l'étage i-1. Cette disposition permet à chaque module de n'avoir qu'une borne d'entrée(9) destinée à être connectée au module de l'étage inférieur, tout en intégrant dans le module la diode Di de l'étage. De plus, lors de la fermeture de l'interrupteur, il est nécessaire que les transistors T1 se bloquent le plus rapidement possible. Or, avec le mode de réalisation représenté sur les figures 6 et 9, le condensateur Cd du détecteur 3, qui en position d'ouverture de l'interrupteur, est chargé à une tension élevée, se décharge à travers la résistance R2 lorsqu'une tension de commande Vco positive est appliquée à l'interrupteur, appliquant ainsi une impulsion négative de tension aux bornes de la résistance R2, qui bloque instantanément le transistor T1.

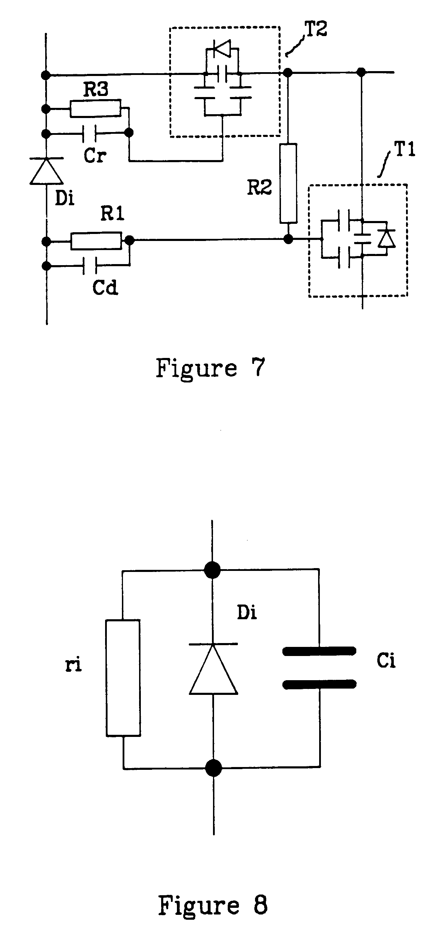

Le module standard 8 comporte pour chaque étage i (i≠1) non seulement le détecteur 3, le régulateur 4 et la diode Di, mais également le condensateur Ci et une résistance ri disposée en parallèle sur le condensateur Ci et la diode Di (figure 8).

En effet, comme illustré sur la figure 7, dans chaque module, le condensateur Ci est réalisé par la combinaison des condensateurs Cd et Cr et des capacités internes des transistors T1 et T2. De même des résistances ri sont réalisées par la mise en série des résistances R1,R2 et de la diode interne du transistor T2 (transistor de type MOSFET).

Les résistances ri forment avec la résistance R5 du dernier étage un pont diviseur destiné à égaliser les tensions appliquées sur les différents étages. Leurs valeurs, de l'ordre du mégohm, sont suffisamment grandes pour que le courant de fuite soit négligeable.

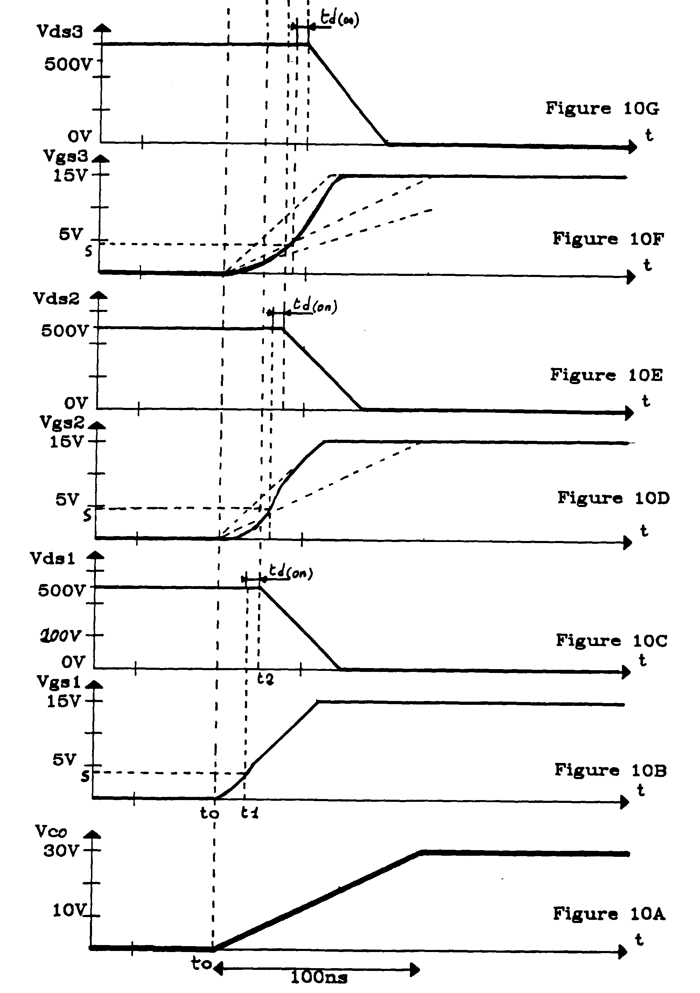

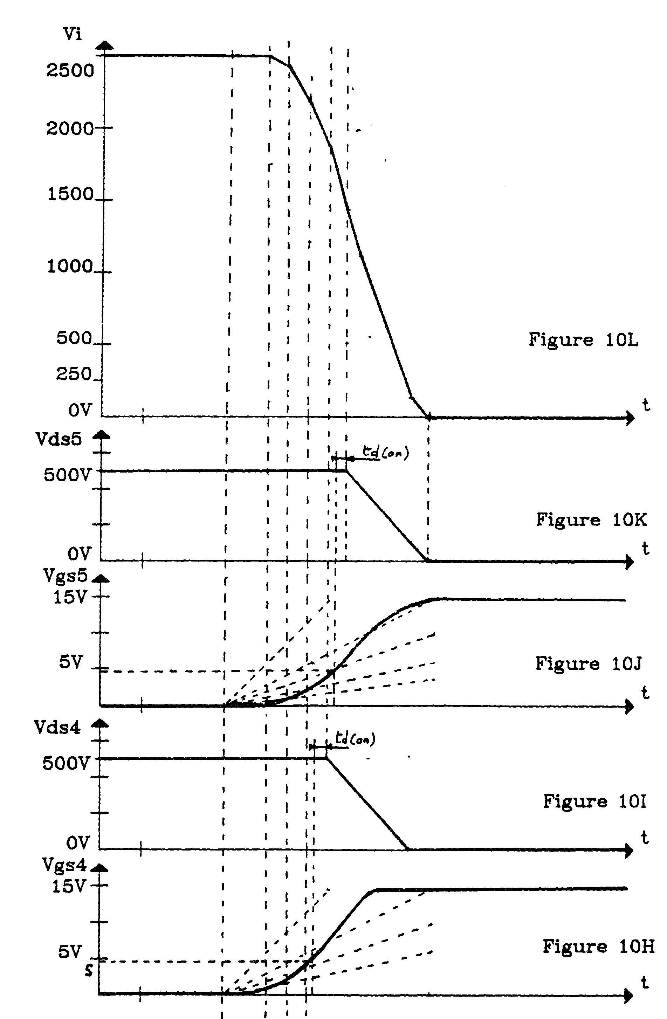

Les figures 10A à 10L représentent les formes d'onde à la fermeture de l'interrupteur des tensions Vgs1 à Vgs5, Vds1 à Vds5 et de la tension Vi aux bornes de l'interrupteur à cinq étages selon la figure 9, alimenté par une tension d'alimentation U de 2500V et commandé par une tension Vco passant de 0V à l'instant to à 30V en 100ns.

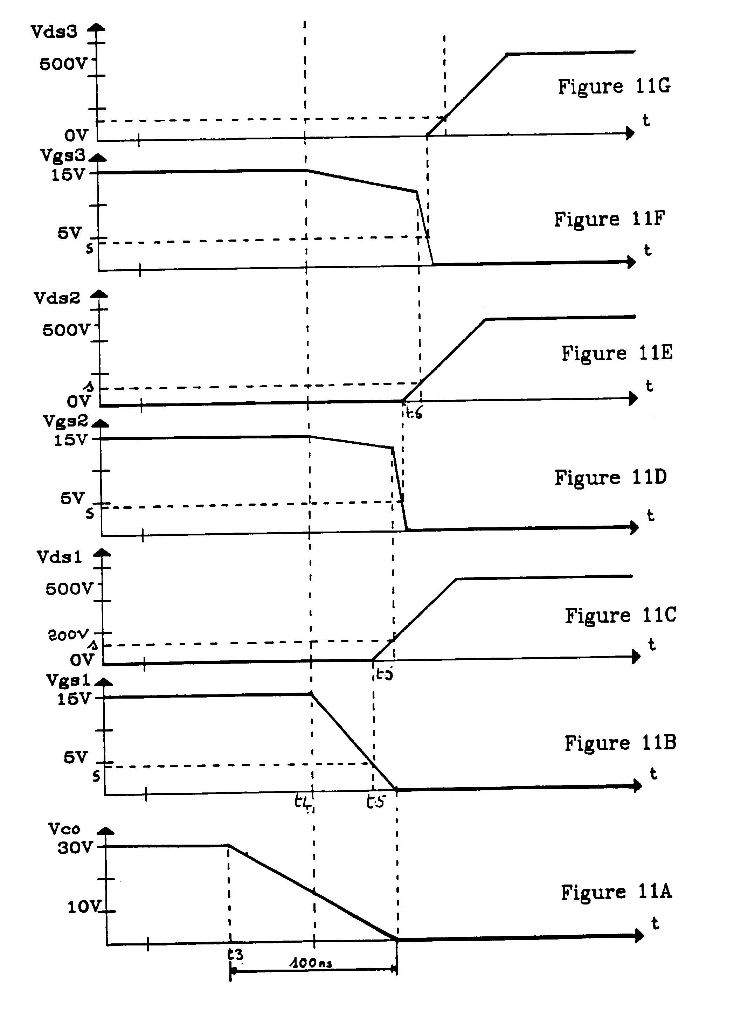

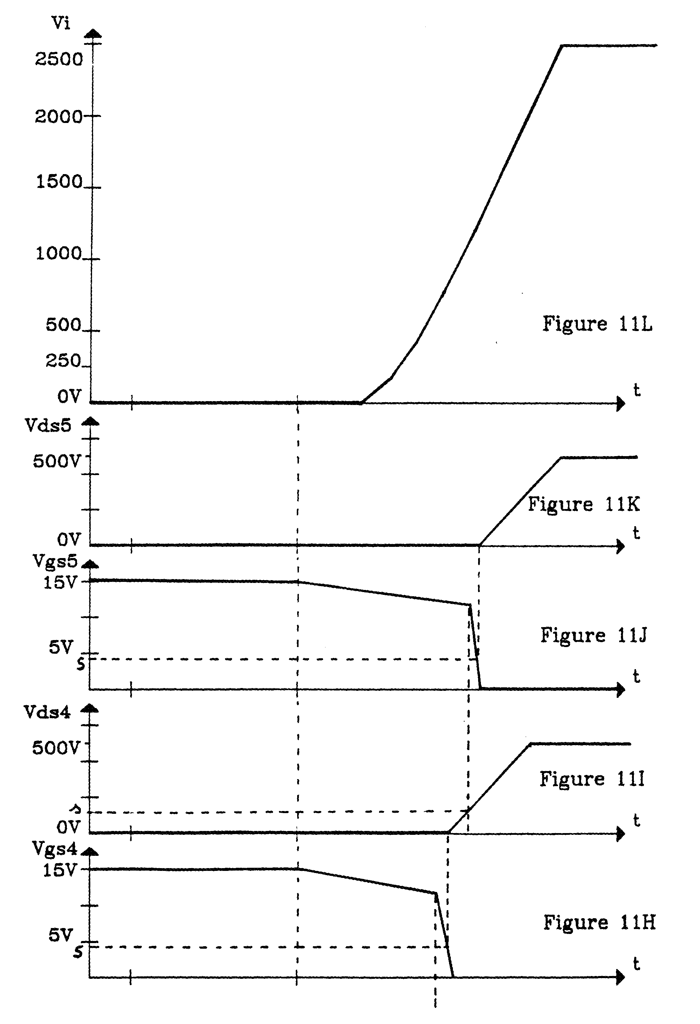

Les figures 11A à 11L représentent les formes d'onde des mêmes tensions lors de l'ouverture de l'interrupteur, lorsque la tension de commande Vco est ramenée à zéro en 100ns.

A la fermeture de l'interrupteur (figures 10A à 10L), la tension de commande Vco est transmise par la ligne capacitive avec une atténuation d'amplitude d'autant plus importante que l'étage est élevé. La tension Vgs1 augmente donc plus rapidement que les tensions Vgs2 à Vgs5 et atteint la première, à l'instant t1, la tension de seuil S du transistor de puissance correspondant, provoquant ainsi l'enclenchement du transistor MOS1 à l'instant t2, avec t2-t1=td(on). Les transistors de puissance des étages supérieurs s'enclenchent successivement lorsque leur tension Vgs atteint la tension de seuil S. Les tensions Vgs1 a Vgs5 sont limitées à 15V par les régulateurs 4.

A l'ouverture de l'interrupteur (figures 11A à 11L), la diminution de la tension de commande Vco à partir de l'instant t3 entraîne une diminution correspondante de la tension Vgs1 à partir de l'instant t4 (retard du au régulateur 4). Lorsque celle-ci passe au-dessous du seuil S à l'instant t5, le transistor MOS1 se bloque. L'augmentation de la tension Vds1 est détectée par le détecteur 3 du second étage, et lorsque la tension Vds1 atteint un seuil s, le détecteur commande l'enclenchement du transistor T1 associé qui court-circuite la jonction grille-source du MOS2. A l'instant t6, Vgs2 passe au dessous du seuil S et bloque le transistor MOS2. Ce processus continue jusqu'au blocage de tous les transistors de puissance. Entre l'instant t4 et l'enclenchement du transistor T1 de l'étage, les capacités grille-source des transistors de puissance des étages supérieurs se déchargent lentement dans la résistance R4 associée.

L'invention permet de commuter très rapidement des tensions importantes pour un courant élevé. A titre d'exemple, un interrupteur à cinq étages selon la figure 9, réalisé en composants discrets, comportant des transistors de puissance MOSFET de type IRF450, alimenté par une tension d'alimentation de 2000V, a permis de commuter un courant de 13A avec un temps de fermeture de l'interrupteur de 200ns et un temps d'ouverture de 320ns.

Pour réduire l'influence des inductions parasites dues aux longueurs des pattes des composants et à la longueur des pistes de circuit imprimé, et en conséquence obtenir des meilleures performances en ce qui concerne les temps de commutation, le dispositif de commande de l'interrupteur sera de préférence réalisé en circuit hybride. Le module standard selon la figure 6 a plus particulièrement été étudié en vue de sa réalisation en circuit hybride.

L'invention n'est pas limitée aux modes de réalisation décrits ci-dessus. En particulier les transistors de puissance peuvent être constitués par tout type de semi-conducteur commandé en tension, par exemple par des transistors de type IGBT.

De même, les transistors de puissance peuvent être constitués par des MOS de type P et non des MOS de type N comme dans les modes particuliers de réalisation représentés, le premier étage étant alors connecté à la borne positive de la tension d'alimentation. La résistance de charge Rc peut, quant à elle, être connectée entre la borne négative de la tension d'alimentation et la source du transistor MOS1, la tension Vco de commande restant appliquée entre la grille et la source du MOS1.

Un condensateur, de même valeur que les condensateurs C2 à C5 des différents étages peut être connecté entre la grille et la source du semi-conducteur de puissance du dernier étage pour complèter la ligne capacitive et équilibrer les tensions. Dans la pratique un tel condensateur n'est pas nécessaire, la capacité interne grille-drain du semi-conducteur de puissance du dernier étage s'avérant suffisante.

## Revendications

1. Interrupteur statique moyenne tension comportant une pluralité de semi-conducteurs de puissance commandables en tension (MOS1-MOS5), comportant chacun une grille, une source et un drain, ces semi-conducteurs de puissance étant connectés en série avec une impédance de charge (Rc) aux bornes d'une tension d'alimentation (U), et un dispositif de commande constituant avec lesdits semi-conducteurs une pluralité d'étages comportant chacun un des semi-conducteurs, le dispositif de commande comportant une entrée de commande unique constituée par des première et seconde bornes de commande (1,2) respectivement connectées à la source et à la grille du semi-conducteur (MOS1) d'un premier étage, de rang un, un condensateur (C2-C5) et une diode (D2-D5) étant connectés en parallèle entre les grilles de deux semi-conducteurs de puissance adjacents, lesdites diodes étant polarisées en inverse lorsque l'interrupteur est ouvert, interrupteur caractérisé en ce que chaque étage de rang (i) supérieur à un comporte un circuit de détection (3) comportant des première (R1) et seconde (R2) résistances connectées soit en série entre les grilles des semi-conducteurs de puissance (MOSi et MOSi-1) dudit étage de rang (i) supérieur à un et de l'étage de rang inférieur adjacent, soit entre la grille du semi-conducteur de puissance (MOSi) dudit étage de rang (i) supérieur à un et la source du semi-conducteur de puissance (MOSi-1) de l'étage de rang inférieur adjacent, un condensateur (Cd) étant connecté en parallèle sur la première résistance et une diode Zener (DZ1) en parallèle sur la seconde résistance (R2), la tension aux bornes de la seconde résistance constituant la tension de sortie du détecteur, la tension de sortie du circuit de détection (3) étant appliquée entre la grille et la source d'un premier semi-conducteur (T1) connecté entre la source et la grille du semi- conducteur de puissance (MOSi) dudit étage de rang supérieur à un, de manière à bloquer ce dernier semi-conducteur de puissance (MOSi) lorsque la tension d'entrée du circuit de détection (3) appliqué sur les première et deuxième résistances dépasse un seuil (s) prédéterminé.

2. Interrupteur selon la revendication 1, caractérisé en ce que chaque étage comporte un régulateur de tension (4) destiné à limiter la tension (Vgs) grille-source appliquée au semi-conducteur de puissance dudit étage.

3. Interrupteur selon la revendication 2, caractérisé en ce que le régulateur de tension (4) comporte une première borne (5), d'entrée, connectée à la cathode de la diode (Di) associée à l'étage pour les étages de rang (i) supérieur à un, et à la seconde borne de commande (2) pour l'étage de rang un, une seconde borne (6), d'entrée-sortie, connectée à la source du semi-conducteur de puissance de l'étage considéré, et une troisième borne (7), de sortie, connectée à la grille du semi-conducteur de puissance de l'étage considéré.

4. Interrupteur selon la revendication 3, caractérisé en ce que le régulateur de tension (4) comporte un second semi-conducteur (T2) connecté entre ses première (5) et troisième (7) bornes, une troisième résistance (R3) connectée en série avec une diode Zener (DZ2) entre ses première (5) et seconde (6) bornes, l'électrode de commande du second semi-conducteur (T2) étant connectée au point commun à ladite diode Zener (DZ2) et à la troisième résistance (R3), de manière à limiter la tension (Vgs) entre les seconde (6) et troisième (7) bornes du régulateur.

5. Interrupteur selon l'une quelconque des revendications 1 à 4, , caractérisé en ce qu'il comporte une résistance (ri) en parallèle sur le condensateur (C2-C5) et la diode (D2-D5) connectant les grilles de deux semi-conducteurs de puissance adjacents, et une résistance additionnelle (R5) connectée entre la grille et le drain du semi-conducteur de puissance (MOS5) de l'étage de rang le plus élevé.

6. Interrupteur selon la revendication 4, caractérisé en ce que, chaque étage de rang (i) supérieur à un comportant un circuit de détection (3) et un régulateur (4), le condensateur (Ci) connecté entre les grilles des semi-conducteurs de puissance dudit étage et de l'étage de rang inférieur adjacent est constitué par la mise en série du condensateur (Cd) du circuit de détection (3) dudit étage (i), des capacités internes des premier et second semi-conducteurs (T1, T2) de type MOS, du détecteur (3) et du régulateur (4) dudit étage, et d'un second condensateur (Cr) connecté en parallèle sur la troisième résistance (R3) dudit régulateur (4), une résistance (ri) connectée en parallèle sur ledit condensateur (Ci) étant constituée par la mise en série des première (R1) et seconde (R2) résistances du détecteur (3) et de la diode interne du second semi-conducteur (T2) du régulateur (4), une résistance additionnelle (R5) étant connectée entre le drain du semi-conducteur de puissance de l'étage de rang le plus élevé et la première borne d'entrée (5) du régulateur (4) de l'étage de rang le plus élevé.

7. Interrupteur selon l'une quelconque des revendications 1 à 6, caractérisé en ce qu'une diode Zener (Z1/-Z5) est connectée en parallèle entre la source et le drain de chaque semi-conducteur de puissance (MOS1-MOS5).

8. Interrupteur selon l'une quelconque des revendications 1 à 7, caractérisé en ce que les semi-conducteurs de puissance sont des transistors de type MOSFET.

**Patentansprüche**

1. Statischer Mittelspannungsschalter mit mehreren spannungsabhängigen Leistungshalbleitern (MOS1 bis MOS5), die jeweils einen Gateanschluß, einen Sourceanschluß und einen Drainanschluß umfassen, wobei diese Leistungshalbleiter in Reihe mit einer Lastimpedanz (Rc) an die Klemmen einer Versorgungsspannung (U) geschaltet sind, sowie einer Steuerschaltung, die zusammen mit den genannten Halbleitern mehrere Schaltstufen mit jeweils einem der Halbleiter bildet, wobei die Steuerschaltung einen einzigen Steuereingang aufweist, der aus an den Source- bzw. Gateanschluß des Halbleiters (MOS1) einer ersten Schaltstufe der Ordnung 1 angeschlossenen ersten und zweiten Steuerklemmen (1, 2) besteht, ein Kondensator (C2 bis C5) sowie eine Diode (D2 bis D5) parallel zwischen die Gateanschlüsse von zwei aufeinanderfolgenden Leistungshalbleitern geschaltet und die genannten Dioden bei geöffnetem Schalter in Sperrichtung gepolt sind, dadurch gekennzeichnet, daß jede Schaltstufe höherer Ordnung (i) als 1 eine Erfassungsschaltung (3) aufweist, die entweder zwischen die Gateanschlüsse der Leistungshalbleiter (MOSi und MOSi-1) der genannten Schaltstufe höherer Ordnung (i) als 1 und der nächstniedrigeren Schaltstufe oder zwischen den Gateanschluß des Leistungshalbleiters (MOSi) der genannten Schaltstufe höherer Ordnung (i) als 1 und den Sourceanschluß des Leistungshalbleiters (MOSi-1) der nächstniedrigeren Schaltstufe in Reihe geschaltete, erste (R1) und zweite (R2) Widerstände, einen parallel zum ersten Widerstand geschalteten Kondensator (Cd) und eine parallel zum zweiten Widerstand (R2) geschaltete Zenerdiode (DZ1) umfaßt, wobei die Spannung an den Klemmen des zweiten Widerstands die Ausgangsspannung der Erfassungsschaltung bildet und die Ausgangsspannung der Erfassungsschaltung (3) zwischen den Gate- und den Sourceanschluß eines ersten, zwischen den Source- und den Gateanschluß des Leistungshalbleiters (MOSi) der genannten Schaltstufe höherer Ordnung als 1 geschalteten Halbleiters (T1) angelegt wird, so daß dieser Leistungshalbleiter (MOSi) in den Sperrzustand geschaltet wird, wenn die an die ersten und zweiten Widerstände angelegte Eingangsspannung der Erfassungsschaltung (3) einen bestimmten Schwellwert (s) überschreitet.

2. Schalter nach Anspruch 1, dadurch gekennzeichnet, daß jede Schaltstufe einen Spannungsregler (4) umfaßt, der dazu dient, die an den Leistungshalbleiter der genannten Schaltstufe angelegte Gate-Source-Spannung (Vgs) zu begrenzen.

3. Schalter nach Anspruch 2, dadurch gekennzeichnet, daß der Spannungsregler (4) eine, in den Schaltstufen höherer Ordnung (i) als 1 an die Kathode der der Schaltstufe zugeordneten Diode (Di) und in der Schaltstufe der Ordnung 1 an die zweite Steuerklemme (2) angeschlossene, erste Eingangsklemme (5), eine an den Sourceanschluß des Leistungshalbleiters der jeweiligen Schaltstufe angeschlossene zweite Eingangs-Ausgangs-Klemme (6) sowie eine an den Gateanschluß des Leistungshalbleiters der jeweiligen Schaltstufe angeschlossene dritte Ausgangsklemme (7) umfaßt.

4. Schalter nach Anspruch 3, dadurch gekennzeichnet, daß der Spannungsregler (4) einen zwischen seine erste (5) und seine dritte (7) Klemme geschalteten zweiten Halbleiter (T2) sowie einen in Reihe mit einer Zenerdiode (DZ2) zwischen seine erste (5) und seine zweite (6) Klemme geschalteten dritten Widerstand (R3) umfaßt, wobei die Steuerelektrode des zweiten Halbleiters (T2) an den Verbindungspunkt zwischen der genannten Zenerdiode (DZ2) und dem dritten Widerstand (R3) angeschlossen ist, um die Spannung (Vgs) zwischen der zweiten (6) und der dritten (7) Klemme des Reglers zu begrenzen.

5. Schalter nach einem der Ansprüche 1 bis 4, dadurch gekennzeichnet, daß er einen, parallel zum Kondensator (C2 bis C5) und zur Diode (D2 bis D5) geschalteten, die Gateanschlüsse von zwei aufeinanderfolgenden Leistungshalbleitern verbindenden Widerstand (ri) sowie einen, zwischen den Gate- und den Drainanschluß des Leistungshalbleiters (MOS5) der Schaltstufe höchster Ordnung geschalteten zusätzlichen Widerstand (R5) umfaßt.

6. Schalter nach Anspruch 4, dadurch gekennzeichnet, daß bei Bestückung jeder Schaltstufe höherer Ordnung (i) als 1 mit einer Erfassungsschaltung (3) und einem Regler (4) der zwischen die Gateanschlüsse der Leistungshalbleiter der genannten Schaltstufe und der nächstniedrigeren Schaltstufe geschaltete Kondensator (Ci) durch die Reihenschaltung des Kondensators (Cd) der Erfassungsschaltung (3) der jeweiligen Schaltstufe (i), der Eingangskapazitäten der ersten und zweiten, als MOSFET ausgelegten Eingangskapazitäten der ersten und zweiten, als MOSFET ausgelegten Halbleiter (T1, T2), der Erfassungsschaltung (3) und des Reglers (4) der jeweiligen Schaltstufe und eines parallel zum dritten Widerstand (R3) des genannten Reglers (4) geschalteten zweiten Kondensators (Cr) gebildet wird, und ein parallel zum genannten Kondensator (Ci) geschalteter Widerstand (ri) durch die Reihenschaltung der ersten (R1) und zweiten (R2) Widerstände der Erfassungsschaltung (3), und des inneren Diodenwiderstands des zweiten Halbleiters (T2) des Reglers (4) gebildet wird, wobei ein zusätzlicher Widerstand (R5) zwischen den Drainanschluß des Leistungshalbleiters der Schaltstufe höchster Ordnung und die erste Eingangsklemme (5) des Reglers (4) der Schaltstufe höchster Ordnung geschaltet wird.

7. Schalter nach einem der Ansprüche 1 bis 6, dadurch gekennzeichnet, daß eine Zenerdiode (Z1 bis Z5) parallel zwischen den Source- und den Gateanschluß jedes Leistungshalbleiters (MOS1 bis MOS5) geschaltet ist.

8. Schalter nach einem der Ansprüche 1 bis 7, dadurch gekennzeichnet, daß die Leistungshalbleiter als MOSFET ausgebildet sind.

**Claims**

1. A medium voltage static switch comprising a plurality of voltage-controllable power semi-conductors (MOS1-MOS5), each comprising a gate, a source and a drain, these power semi-conductors being connected in series with a load impedance (Rc) to the terminals of a supply voltage (U), and a control device forming with said semi-conductors a plurality of stages each comprising one of the semi-conductors, the control device comprising a single control input formed by first and second control terminals (1, 2) respectively connected to the source and gate of the semi-conductor (MOS1) of a first stage, of rank one, a capacitor (C2-C5) and a diode (D2-D5) being connected in parallel between the gates of two adjacent power semi-conductors, said diodes being reverse polarized when the switch is open, a switch characterized in that each stage of rank (i) higher than one comprises a detection circuit (3) comprising first (R1) and second (R2) resistances connected either in series between the gates of the power semi-conductors (MOSi and MOSi-1) of said stage of rank (i) higher than one and of the stage of adjacent lower rank, or between the gate of the power semi-conductor (MOSi) of said stage of rank (i) higher than one and the source of the power semi-conductor (MOSi-1) of the stage of adjacent lower rank, a capacitor (Cd) being connected in parallel to the first resistance and a Zener diode (DZ1) in parallel to the second resistance (R2), the voltage at the terminals of the second resistance constituting the output voltage of the detector, the output voltage of the detection circuit (3) being applied between the gate and source of a first semi-conductor (T1) connected between the source and gate of the power semi-conductor (MOSi) of said stage of rank higher than one, so as to turn the latter power semi-conductor (MOSi) off when the input voltage of the detection circuit (3) applied to the first and second resistances exceeds a preset threshold (s).

2. The switch according to claim 1, characterized in that each stage comprises a voltage regulator (4) designed to limit the gate-source voltage (Vgs) applied to the power semi-conductor of said stage.

3. The switch according to claim 2, characterized in that the voltage regulator (4) comprises a first, input, terminal (5), connected to the cathode of the diode (Di) associated to the stage for the stages of rank (i) higher than one, and to the second control terminal (2) for the stage of rank one, a second, input-output, terminal (6) connected to the source of the power semi-conductor of the stage involved, and a third, output, terminal (7) connected to the gate of the power semi-conductor of the stage involved.

4. The switch according to claim 3, characterized in that the voltage regulator (4) comprises a second semi-conductor (T2) connected between its first (5) and third (7) terminals, a third resistance (R3) connected in series with a Zener diode (DZ2) between its first (5) and second (6) terminals, the control electrode of the second semi-conductor (T2) being connected to the point common to said Zener diode (DZ2) and to the third resistance (R3), so as to limit the voltage (Vgs) between the second (6) and third (7) terminals of the regulator.

5. The switch according to any one of the claims 1 to 4, characterized in that it comprises a resistance (ri) in parallel with the capacitor (C2-C5) and diode (D2-D5) connecting the gates of two adjacent power semi-conductors, and an additional resistance (R5) connected between the gate and drain of the power semi-conductor (MOS5) of the stage of highest rank.

6. The switch according to claim 4, characterized in that each stage of rank (i) higher than one comprising a detection circuit (3) and a regulator (4), the capacitor (Ci) connected between the gates of the power semi-conductors of said stage and of the stage of adjacent lower rank is formed by serial connection of the capacitor (Cd) of the detection circuit (3) of said stage (i), internal capacitors of the first and second MOS-type semi-conductors (T1, T2) of the detector (3) and regulator (4) of said stage, and a second capacitor (Cr) connected in parallel to the third resistance (R3) of said regulator (4), a resistance (ri) connected in parallel to said capacitor (Ci) being constituted by serial connection of the first (R1) and second (R2) resistances of the detector (3) and internal diode of the second semi-conductor (T2) of the regulator (4), an additional resistance (R5) being connected between the drain of the power semi-conductor of highest rank and the first input terminal (5) of the regulator (4) of highest rank.

7. The switch according to any one of the claims 1 to 6, characterized in that a Zener diode (Z1/-Z5) is connected in parallel between the source and drain of each power semi-conductor (MOS1-MOS5).

8. The switch according to any one of the claims 1 to 7, characterized in that the power semi-conductors
are MOSFET-type transistors.

Figure 1

Figure 2

Figure 3

Figure 4

Figure 5

Figure 6

Figure 7

Figure 8

Figure 9

EP 0 453 376 B1

Figure 10G

Figure 10F

Figure 10E

Figure 10D

Figure 10C

Figure 10B

Figure 10A

16

Figure 10L

Figure 10K

Figure 10J

Figure 10I

Figure 10H

Figure 11G

Figure 11F

Figure 11E

Figure 11D

Figure 11C

Figure 11B

Figure 11A

18

Figure 11L

Figure 11K

Figure 11J

Figure 11I

Figure 11H